# FASCICULE DE BREVET EUROPEEN

(11) **EP 2 912 682 B1**
(45) Date de publication et mention de la délivrance du brevet: **15.02.2023**
(21) Numéro de dépôt: 13780170.0
(22) Date de dépôt: 24.10.2013
(51) Int. Cl.: H01L 21/203, H01L 21/205

(54) **PROCEDE DE FABRICATION D'UNE STRUCTURE SEMICONDUCTRICE**
VERFAHREN ZUR HERSTELLUNG EINER HALBLEITENDEN STRUKTUR
METHOD FOR PRODUCING A SEMI-CONDUCTIVE STRUCTURE

(30) Priorité: 26.10.2012 FR 1260234
(43) Date de publication de la demande: 02.09.2015
(73) Titulaire: Commissariat à l'Énergie Atomique et aux Énergies Alternatives, 75015 Paris (FR)
(72) Inventeur: VAUFREY, David, 38000 Grenoble (FR); BONO, Hubert, 38000 Grenoble (FR)
(74) Mandataire: Brevalex
(86) Numéro de dépôt international: PCT/EP2013/072326
(87) Numéro de publication internationale: WO 2014/064220

(56) Documents cités:
- WO-A1-2012/075461
- WO-A2-2009/009612
- WO-A2-2012/050888
- KR-A- 20060 118 845
- US-A1- 2007 108 466
- DUPUIS R D ED - AKIMOTO KATSUHIRO ET AL: "Epitaxial growth of III-V nitride semiconductors by metalorganic chemical vapor deposition", JOURNAL OF CRYSTAL GROWTH, ELSEVIER, AMSTERDAM, NL, vol. 178, no. 1-2, 1 June 1997 (1997-06-01), pages 56-73, XP004084975, ISSN: 0022-0248, DOI: 10.1016/S0022-0248(97)00079-1

## Description

### DOMAINE TECHNIQUE

L'invention se rapporte au domaine des composants de l'électronique et de l'optoélectronique à base de structures semiconductrices.

Dans le but d'améliorer les performances des composants semiconducteurs, les recherches à ce sujet se sont focalisées sur les structures de tailles micrométriques, voire nanométriques.

En effet, l'utilisation de telles structures procure plusieurs avantages. Parmi ceux-ci, on peut notamment citer le fait que de telles structures offrent la possibilité de développer des composants qui ne sont plus planaires mais à trois dimensions. Ainsi, on augmente significativement la surface fonctionnelle du composant sans augmentation significative de ses dimensions. Ceci est particulièrement le cas des fils semiconducteurs.

Parmi les axes de recherche sur ces structures, et notamment sur les fils semiconducteurs, l'optimisation des procédés permettant leur fabrication de manière contrôlée reste prioritaire.

Ainsi l'invention concerne particulièrement un procédé de fabrication d'une structure semiconductrice et un composant semiconducteur.

### ÉTAT DE LA TECHNIQUE ANTÉRIEURE

Les procédés de fabrication contrôlés de structures semiconductrices telles que les fils de nitrure de gallium (GaN) doivent prendre en compte les contraintes liées au type de structures semiconductrices et aux matériaux les constituant, ainsi que les contraintes liées aux matériaux composant le support.

En effet, la méthode généralement employée pour la formation des structures sur un support consiste à déposer le matériau dans lequel doivent être formées les structures. Ce dépôt est réalisé de manière à ce que le matériau à déposer croisse sélectivement uniquement sur certaines zones du support, qui sont dites zones de formation. Cette croissance sélective peut être obtenue de différentes manières en fonction des matériaux composant les structures et du matériau de la surface du support.

Ainsi, il est connu de l'état de la technique d'obtenir cette sélectivité de croissance en modifiant préalablement et localement les zones de formation, par exemple par texturation de surface, de manière à former des centres de nucléation pour le matériau à déposer. Ainsi, on abaisse sur les zones de formation l'énergie de nucléation du matériau à déposer ce qui permet de favoriser la croissance dudit matériau sur les zones modifiées. Lors du dépôt du matériau à déposer sur la surface du support, le matériau va croître donc préférentiellement sur les zones de formation et former les germes pour la croissance des structures. Après formation des germes, la différence d'énergie de nucléation du matériau entre le support et les germes, favorise significativement le dépôt du matériau sur les germes et permet de rendre sélective la croissance. On forme ainsi les structures uniquement sur les zones de formation.

Si un tel procédé permet la formation contrôlée de structures sur la surface d'un support, il présente néanmoins un inconvénient majeur. En effet, les méthodes permettant de modifier la surface sont des méthodes locales, donc séquentielles, telles que les techniques de modifications de surface en microscopie champ proche ou encore par focalisation de faisceaux d'ions. Il en résulte donc que pour fabriquer des structures sur des surfaces importantes, telles que celle d'une tranche de silicium de 20 cm de diamètre, l'étape de modification de la surface prend un temps long qui est peu compatible avec les contraintes de fabrication de masse.

Il est également connu de l'état de la technique, et notamment du brevet US 8039854, d'obtenir la sélectivité de croissance du matériau à déposer au moyen d'un masque préalablement déposé à la surface du support. Dans un tel procédé, le masque est réalisé dans un matériau sur lequel la croissance du matériau à déposer est réduite, voire inhibée. Le masque est également conformé de manière à laisser libres uniquement les zones de formation. Ainsi, le matériau à déposer ne peut croître que sur les zones de formation, sa croissance sur le reste de la surface du support étant limitée, voire inhibée, par le masque.

Ce procédé présente l'avantage d'être compatible, pour la libération des zones de formation, avec les méthodes de photolithographie. Ainsi les étapes nécessaires pour former le masque, notamment l'étape de libération des zones de formation, peuvent être réalisées en parallèle sur toute la surface du support quelle que soit la taille du support. Ainsi, ce procédé ne nécessitant pas de faire appel à une méthode de modification de surface du type locale donc séquentielle, il ne présente donc pas d'étape qui ne soit pas compatible avec les contraintes de fabrication de masse.

Néanmoins, que le procédé de fabrication employé soit un procédé de fabrication séquentiel ou un procédé de fabrication en parallèle, un procédé de fabrication de structures comprenant du gallium (Ga) sur une surface comportant du silicium reste particulièrement problématique dans la mesure où un phénomène de gravure du silicium (Si) par le gallium (Ga) entre en compétition avec le phénomène de cristallisation du matériau à déposer.

Il en résulte que pour la formation de structures comportant du gallium (Ga) sur une surface comportant du silicium (Si), il est nécessaire soit de préalablement protéger avec une couche de protection la surface du support, telle qu'une couche de nitrure d'aluminium (AIN) qui présente l'inconvénient d'être peu conductrice, soit de rechercher les conditions de croissance spécifiquement adaptées aux structures à former. Ces deux solutions restent peu idéales, la première ne permettant pas la formation d'un bon contact électrique entre le support et les structures formées et la deuxième nécessitant une longue procédure d'adaptation pour chaque type de structure à former.

Des méthodes de croissance de fils semiconducteurs sont également connues des documents WO 2019/009612 A2, KR 2006/0118845 A, WO 2012/075461 A1.

Des méthodes de croissance de couches semiconductrices III-V également connu des documents US 2007/108466 A1, WO 2012/050888 A2 et des travaux de R. D. Dupuis publiés dans « Journal of Crystal Growth » Volume 178 numéro 1-2 pages 56-73 en 1997.

### EXPOSÉ DE L'INVENTION

La présente invention vise à remédier à ces inconvénients.

Un but de l'invention est donc de fournir un procédé de fabrication d'une structure semiconductrice à la surface d'un support, la structure comportant du gallium et la surface du support comprenant du silicium, ne présentant pas les problèmes inhérents à l'utilisation d'une couche de nucléation de nitrure d'aluminium (AIN) et ne nécessitant pas de longue procédure d'adaptation.

A cet effet l'invention concerne un procédé de fabrication selon la revendication 1.

On entend ci-dessus et dans le reste de ce document par « formation de la couche à une température inférieure à 600°C » que la température de la surface du support ne dépasse pas en moyenne pendant la croissance de la couche une température de 600°C, soit 873 K.

Les zones de formation ainsi réalisées, de par leur composition adaptée pour la formation des structures, présentent une énergie de nucléation inférieure à celle de la surface du support et favorisent ainsi la formation de la structure à la surface. On obtient ainsi une croissance sélective des structures qui est contrôlée au moyen des zones de formation ceci sans la nécessité d'un masque sur le reste de la surface et l'aménagement préalable d'une couche de nitrure d'aluminium (AIN).

De plus, l'élaboration de la couche du premier matériau sur les zones de formation étant compatible avec les méthodes de photolithographie et donc réalisable en parallèle sur toute la surface du support quelles que soient ses dimensions. Cette possibilité rend donc un tel procédé particulièrement adapté pour la fabrication de masse de structures semiconductrices.

L'étape de formation de la couche d'un premier matériau comporte une sous-étape de dépôt du premier matériau du type dépôt physique en phase vapeur.

Une telle sous-étape de dépôt du premier matériau permet de former une couche du premier matériau en limitant l'interaction entre le gallium et la surface du support. En effet, une méthode de dépôt du type dépôt physique en phase vapeur permet de réaliser le dépôt à faible température et une partie du matériau déposé l'est sous forme de cations dont la composition est dérivée de celle du matériau à déposer et non sous forme d'atomes. Ainsi, cette basse température de dépôt et le fait que certains des atomes de gallium déposés sont liés à d'autres atomes réduit les risques d'interaction entre les atomes de gallium et les atomes de la surface du support.

Il peut être prévu, entre l'étape de formation de la couche du premier matériau et l'étape de formation de la structure, une étape de nitruration de la zone libre de la surface.

Une telle étape de nitruration permet de former avec le silicium présent à la surface un nitrure de silicium, ceci uniquement sur la zone de la surface non protégée par la première couche, c'est-à-dire la zone libre. Ainsi, de par ce changement de composition de sa surface, la zone libre présente une réactivité réduite vis-à-vis du gallium (Ga). Cette couche de nitrure de silicium permet également de passiver électriquement la surface du support au niveau de la zone libre évitant ainsi la réalisation après la croissance de la structure , d'une coûteuse étape supplémentaire de passivation.

L'étape de formation de la structure semiconductrice peut comporter une étape de croissance du premier matériau sur la première couche par épitaxie en phase vapeur utilisant des précurseurs organométalliques de manière à former au moins une partie de la structure semiconductrice en contact avec la première couche.

L'étape de formation de la couche d'un premier matériau peut comporter les sous-étapes consistant à :
- former une couche de protection recouvrant uniquement la zone libre de la surface,
- déposer le premier matériau sur la zone de formation, la zone libre étant protégée par la couche de protection,
- retirer la couche de protection.

L'étape de formation de la couche peut comporter les sous-étapes consistant à :
- déposer le premier matériau sur toute la surface du support,
- retirer la partie du premier matériau qui recouvre la zone libre.

Ces deux possibilités permettent de former la couche du premier matériau uniquement sur les zones de formation et permet ainsi de former le fil uniquement sur la zone de formation.

Le support peut comporter, au moins à sa surface, du silicium dans une proportion massique supérieure à 30%, la surface du support étant préférentiellement essentiellement composée de silicium.

Un tel procédé est particulièrement adapté pour être mis en oeuvre avec un tel support. En effet, le gallium présentant une forte réactivité avec le silicium, un tel procédé permet de s'affranchir de l'influence de cette réactivité sur les structures formées par un tel procédé sur un support présentant une forte proportion massique en silicium.

L'étape de formation de la structure semiconductrice est une étape de formation d'un fil semiconducteur qui est, au moins pour sa partie en contact avec la couche, réalisé dans le premier matériau, en nitrure de gallium (GaN).

Une possibilité non comprise dans l'invention concerne un composant comportant :
- un support dont la surface comprend du silicium,
- une structure semiconductrice,
   le composant comportant en outre
- une couche d'un premier matériau en contact avec la surface du support sur une zone de la surface qui est dite zone de formation, le reste de la surface du support étant dit zone libre, le premier matériau comportant du gallium,
   la structure étant en contact avec la couche du premier matériau.

Un tel composant selon cette possibilité peut aisément être réalisé au moyen d'un procédé selon l'invention, ceci sans nécessiter, contrairement à un composant selon l'art antérieur, une lourde étape de fourniture d'un masque dur sur la surface pour la formation de la structure semiconductrice. On évite ainsi tout risque de contamination de la structure lié au procédé de suppression du masque dur qui doit généralement être réalisé pour un composant de l'art antérieur après la formation de la structure.

Le support peut présenter, au moins à sa surface, une proportion massique de 20% de silicium (Si).

Le support peut être un support en silicium Si.

Un tel composant comporte une interface entre la structure et le support qui est améliorée par rapport à un composant de l'art antérieur dont le support présente à sa surface cette même proportion massique. En effet, avec un tel composant la formation de la structure n'entraîne pas d'interaction entre le silicium du support et le gallium de la structure qui dégrade l'interface entre la structure et le support ceci sans nécessiter une couche tampon.

La surface du support de la zone libre peut être formée dans un matériau nitruré.

La structure peut être un fil semiconducteur avec, au moins pour sa partie en contact avec la couche, réalisé dans le premier matériau, en nitrure de gallium GaN.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- les figures 1a à 1e illustrent des vues en coupe des différentes étapes de formation de structures selon un premier mode de réalisation
- les figures 2a à 2d illustrent des vues en coupe des différentes étapes d'élaboration de la couche du premier matériau sur les zones de formation selon un deuxième mode de réalisation de l'invention,
- les figures 3a et 3b illustrent respectivement une vue en coupe de l'étape de nitruration des zones libres de la surface et l'étape de croissance des structures selon un troisième mode de réalisation de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

La présente invention concerne la fabrication de structures tridimensionnelles, par exemple de microfils, de nanofils ou d'éléments en forme de pyramide. Dans la suite de la description, des modes de réalisation sont décrits pour la fabrication de microfils ou de nanofils. Toutefois, ces modes de réalisation peuvent être mis en oeuvre pour la fabrication de structures tridimensionnelles autres que des microfils ou des nanofils, par exemple pour la fabrication d'éléments tridimensionnels en forme de pyramide.

Dans l'ensemble de ce document, on entend par fils, nanofils ou microfils semiconducteurs des structures semiconductrices présentant trois dimensions et de forme allongée, dont deux sont du même ordre de grandeur comprises entre une 5 nm et 2,5 µm, la troisième dimension étant au moins égale à 2 fois, 5 fois ou préférentiellement 10 fois la plus grande des deux autres dimensions.

Les dimensions transversales sont inférieures ou égales à environ 1 µm, de préférence comprises entre 100 nm et 300 nm. Dans certains modes de réalisation, la hauteur de chaque nanofil, ou dimension longitudinale, peut être supérieure ou égale à 500 nm, de préférence comprise entre 1 µm et 50 µm.

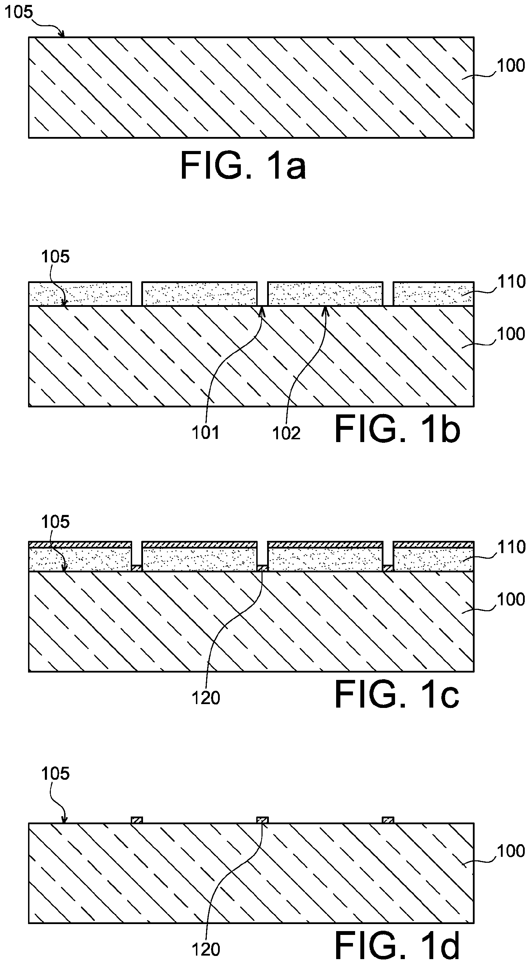

Les figures 1a à 1e illustrent les principales étapes d'un procédé de fabrication de structures selon un premier mode de réalisation de l'invention dans une application particulière aux fils 130 semiconducteurs en nitrure de gallium (GaN) sur un support 100 en silicium (Si).

Une telle application particulière est une application préférée de l'invention. L'invention ne se limite néanmoins pas à la fabrication de fils 130 de nitrure de gallium (GaN) sur support 100 en silicium (Si) et englobe également les procédés de fabrication de fils semiconducteurs réalisés dans un autre matériau semiconducteur que le nitrure de gallium qui comporte du gallium, tel que l'arséniure de gallium (GaAs), le nitrure de gallium-indium (InGaN) ou le nitrure de gallium-aluminium (AIGaN), sur un support qui peut être du silicium ou être un support comportant au niveau de sa surface du silicium.

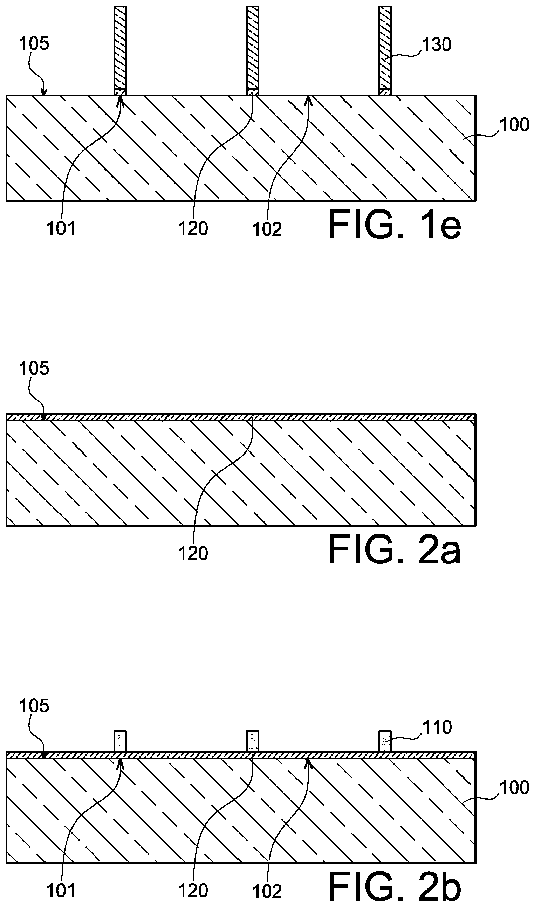

Un tel procédé de fabrication comporte les étapes consistant à :
- fournir le support 100, tel que cela est illustré sur la figure 1a,
- déposer, comme cela est illustré sur la figure 1b, un masque 110 sur la surface du support, ce masque 110 laissant libres uniquement les zones 101 de la surface qui sont destinées à la formation des fils semiconducteurs et qui sont dites zones de formation, le reste 102 de la surface 105 représentant une zone qui est dite libre,
- déposer, comme illustré sur la figure 1c, une couche 120 d'un premier matériau comportant du gallium sur les zones de formation 101, la zone libre 102 étant protégée par le masque 110,
- supprimer, comme cela est illustré sur la figure 1d, le masque 110 de manière à libérer la zone libre 102 et ne laisser à la surface 105 que les zones de formation 101 recouvertes du premier matériau, la zone libre 102 étant libre du premier matériau et de masque 110,
- faire croître, comme illustré sur la figure 1e, les fils 130 en déposant un deuxième matériau comportant du gallium, cette croissance ayant lieu principalement en contact avec les zones de formation 101 qui présentent, en raison de la composition du premier matériau, une énergie de nucléation inférieure à celle de la zone libre 102.

L'étape de fourniture du support 100 consiste plus particulièrement en la fourniture d'un support sensiblement plat dont l'une des surfaces 105 est destinée à la formation de fils 130 semiconducteurs. Un tel support 100 est généralement un support semiconducteur tel que par exemple un support en silicium (Si), en carbure de silicium (SiC) ou encore en saphir (Al₂O₃) qui comporte une surface comprenant du silicium (Si).

Pour simplifier la compréhension, dans la suite de ce document, on entend par surface, la surface 105 du support 100 qui est destinée à la formation des fils 130. Selon l'invention, cette surface est formée en un matériau comportant du silicium.

Le support 100 peut également être réalisé dans un matériau non semiconducteur comme du verre (SiO₂), ou seulement comporter une couche semiconductrice s'étendant le long de la surface 105 destinée à la formation des fils 130, ceci sans que l'on sorte du cadre de l'invention. Selon une possibilité particulièrement adaptée pour l'application de l'invention, le support 100 présente à sa surface 105 une proportion massique de silicium (Si) supérieure à 30%.

Comme indiqué plus haut, dans l'application particulière, le support 100 est un support en silicium utilisé dans les industries de la micro-électronique et de l'optoélectronique. Le type de conductivité et la concentration en porteurs majoritaires sont définis en fonction du type de composant qui est destiné à être formé à partir des fils 130 obtenus au moyen du procédé de fabrication selon l'invention. Ainsi, le support peut être, par exemple, d'un type de conductivité pour lequel les porteurs majoritaires sont des électrons avec une concentration en porteurs majoritaires supérieure à 10¹⁸ cm⁻³. Une telle concentration est particulièrement adaptée pour

Le masque 110 formé lors de l'étape de formation du masque 110 est un masque classiquement utilisé dans l'industrie de la microélectronique tel que par exemple un masque en silice, en nitrure de silicium ou encore, dans le cas où la température de dépôt de la couche 120 est inférieure à 100°C, une résine polymère. Le masque 110 est adapté pour recouvrir la zone libre 102 et laisser libres les zones de formation 101. De telles étapes de formation de masques 110 étant bien connues de l'homme du métier, cette étape ne sera pas décrite plus précisément dans ce document.

Le masque 110 forme une couche de protection de la zone libre.

Pour l'application particulière, chacune des zones de formation 101 se présente sous la forme d'un disque dont le diamètre est compris entre 50 nm et 5 µm. Ainsi, il est possible de répartir les zones de formation 101 sur la surface du support avec une densité comprise entre 10⁵ et 10⁸ zones par centimètre carré. Bien entendu, selon cette application particulière la forme de chacune des zones de formation 101 peut être autre que celle d'un disque telle que par exemple une forme délimitée par un hexagone, par un carré ou encore par un rectangle.

La couche 120 de premier matériau qui est déposée pendant l'étape de dépôt du premier matériau est composée d'un matériau semiconducteur contenant du gallium Ga. Ainsi le premier matériau peut être aussi bien un semiconducteur binaire, tel que l'arséniure de gallium (GaAs) et le nitrure de gallium (GaN), qu'un semiconducteur ternaire, tel que l'arséniure de gallium-indium (InGaAs), le nitrure de gallium-indium (InGaN) et le nitrure gallium-aluminium (AIGaN), ou un semiconducteur quaternaire tel que par exemple l'arséniure-phosphure de gallium-indium (InGaAsP).

Cette étape de dépôt du premier matériau est réalisée par une méthode de dépôt adaptée pour que la température de formation de la couche 120 du premier matériau reste inférieure à 600°C (ou 873 K). Une telle température de formation de la couche 120 du premier matériau signifie que la température de la surface 105 du support est en moyenne inférieure à 600°C pendant toute l'étape de formation de la couche 120. La température de la surface 105 du support est, selon une possibilité préférée de l'invention inférieure à 600°C pendant toute l'étape de formation de la couche 120.

Ainsi lors de cette étape, la méthode de dépôt employée est une méthode de dépôt physique en phase vapeur (plus connue sous sa dénomination anglaise « Physical Vapor Déposition » ou le sigle anglais PVD qui lui est associé) selectionnée dans le groupe comporant la pulvérisation cathodiqueet la méthode de dépôt par ablation laser pulsé (plus connue sous sa dénomination anglaise « Pulsed Laser Déposition » ou le sigle anglais PLD qui lui est associé).

Une méthode de dépôt autorisant une température de formation de la couche du premier matériau qui est inférieur à 600°C permet de limiter l'interaction entre les atomes de gallium du premier matériau et ceux de la surface 105 lors de la formation de la première couche 120. On évite ainsi une détérioration à la fois de la surface 105 et de la couche 120 du premier matériau qui serait préjudiciable à la formation des structures.

Lors de cette étape l'épaisseur de la couche 120 de matériau déposée est préférentiellement choisie entre 3 nm et 100 nm et de manière avantageuse comprise entre 3 et 30 nm.

Dans l'application particulière, les fils 130 qui sont destinés à être formés sur la surface 105 étant des fils de nitrure de gallium GaN, le premier matériau est du nitrure de gallium GaN et la couche 120 dudit premier matériau est formée lors d'un dépôt par pulvérisation cathodique réactive. Selon cette possibilité, le matériau déposé peut comporter une faible proportion de silicium afin de former une couche 120 du premier matériau en nitrure de gallium GaN avec du silicium en tant qu'élément dopant.

L'étape de suppression du masque 110 est réalisée lors d'une gravure sélective du matériau formant le masque 110 qui est adaptée pour ne pas graver la surface 105 du support et celle du premier matériau. Cette gravure peut être soit une gravure par voie liquide soit une gravure par voie sèche, telle qu'une attaque par ions réactifs (plus connue sous la dénomination anglaise « reactive ion etching »). De telles gravures sélectives étant connues de l'homme du métier et n'étant pas spécifiques à l'invention, elles ne sont pas explicitées plus précisément dans ce document.

En ce qui concerne l'étape de formation des structures 130, celle-ci est obtenue par une méthode de dépôt classiquement utilisée pour la formation de structure semiconductrice. Dans cette étape, le deuxième matériau est sensiblement identique au premier matériau. Un deuxième matériau sensiblement identique au premier matériau permet aux zones de formation 101 de présenter une énergie de nucléation lors du dépôt du deuxième matériau qui est bien inférieure à celle de la surface de la zone libre 102. En effet, dans ces conditions, le paramètre de maille de la couche 120 du premier matériau étant sensiblement identique à celui du deuxième matériau, le dépôt du deuxième matériau sur la couche 120 du premier matériau est en fait de l'homo-épitaxie. On assure donc ainsi une bonne sélectivité de la croissance des structures 130 qui a lieu principalement, voire exclusivement, sur les zones de formation 101.

Dans l'application particulière, le deuxième matériau est sensiblement identique au premier matériau et est donc du nitrure de gallium GaN. Dans cette même application particulière, la méthode de dépôt utilisée pendant l'étape de formation des structures 130 est préférentiellement une étape de dépôt chimique en phase vapeur à précurseurs métallo-organiques (plus connue sous son sigle anglais MOCVD).

Bien entendu, que ce soit dans le cadre général de l'invention ou dans le cadre de l'application particulière, seule la composition de la partie de chacune des structures 130 qui est formée en contact avec la zone de formation 101 correspondante est formée d'un deuxième matériau sensiblement identique au premier matériau. Le reste de chacune des structures 130 peut présenter une composition différente de manière à former pour chacune des structures des zones fonctionnelles en fonction de l'application visée.

Un tel procédé permet donc la fabrication de structures 130 comportant du gallium (Ga) en offrant, en favorisant la croissance des structures 130 sur des zones de la surface du support, un contrôle sur la formation des structures. Il est de plus adapté pour la fabrication de masse de structures et ne présente pas les problèmes inhérents à l'utilisation d'un masque 110 pendant la croissance des structures 130.

De telles structures 130 sont adaptées pour la fabrication d'un composant semiconducteur. Un tel composant, non illustré, comporte
- un support 100,
- une couche 120 du premier matériau en contact avec la surface 105 du support 100 sur les zones de formation 101, le premier matériau comportant du gallium,
- une pluralité de structures 130 semiconductrices chacun en contact avec l'une des zones de formation 101.

Les figures 2a à 2d illustrent les principales étapes d'un procédé de fabrication selon un deuxième mode de réalisation de l'invention. Un tel procédé se différencie d'un procédé selon le premier mode de réalisation en ce que l'étape de formation a lieu sur toute la surface 105 du support 100 sur laquelle est destinée à être formées les structures 130, en ce que le masque 110 est déposé en contact uniquement avec les zones de formation 101, la zone libre 102 étant libre de masque et en ce qu'il est en outre prévu, entre l'étape de formation du masque 110 et l'étape de suppression du masque 110, une étape de gravure sélective adaptée pour graver les parties de la couche 120 du premier matériau qui n'est pas protégée par le masque 110.

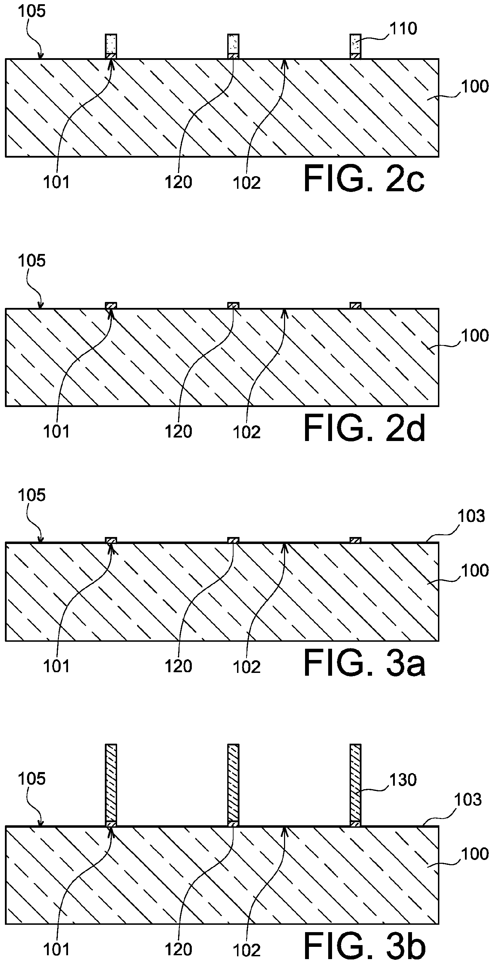

Ainsi un procédé de fabrication selon ce deuxième mode de réalisation comporte les étapes consistant à :
- fournir le support 100, de manière identique à l'étape du procédé de fabrication selon le premier mode de réalisation qui est illustré sur la figure 1a,
- déposer, comme illustré sur la figure 2a, une couche 120 du premier matériau comportant du gallium sur la surface 105 du support 100 qui est destinée à être en contact avec les structures 130,
- déposer, comme cela est illustré sur la figure 2b, un masque 110 sur la surface de la couche 120 du premier matériau, ce masque 110 recouvrant uniquement les zones de formation 101, les parties de la couche 120 du premier matériau qui recouvrent la zone libre 102 n'étant pas recouvertes par le masque 110,
- supprimer, comme cela est illustré sur la figure 2c, les parties de la couche 120 du premier matériau qui recouvrent la zone libre 102, les parties de la couche 120 du premier matériau qui recouvre les zones de formation 101 étant protégées par le masque 110,
- supprimer, comme cela est illustré sur la figure 2d, le masque 110 de manière à libérer les parties de la couche 120 du premier matériau qui recouvre les zones de formation 101,
- faire croître, de manière identique à l'étape du procédé de fabrication selon le premier mode de réalisation qui est illustré sur la figure 1e, les fils 130 en déposant un deuxième matériau comportant du gallium Ga, cette croissance ayant lieu principalement en contact avec les zones de formation 101 qui présentent, en raison de la composition du premier matériau, une énergie de nucléation inférieure à celle de la zone libre 102.

En ce qui concerne l'étape de suppression des parties de la couche 120 du premier matériau qui recouvrent la zone libre 102, elle peut être réalisée au moyen d'une gravure sélective de la couche 120 du premier matériau qui est adaptée pour ne pas graver la surface du support 100 et le masque 110.

Les autres étapes du procédé selon le deuxième mode de réalisation de l'invention sont identiques à celles d'un procédé selon le premier mode réalisation de l'invention.

Les figures 3a et 3b illustrent deux étapes d'un procédé de fabrication selon un troisième mode de réalisation de l'invention. Un procédé de fabrication selon ce troisième mode de réalisation se différencie d'un procédé selon le deuxième mode de réalisation en ce qu'il comporte entre l'étape de suppression du masque 110 et l'étape de formation des fils 130, une étape de nitruration de la surface 105 de la zone libre 102.

L'étape de nitruration consiste à soumettre le support 100 à un flux d'azote N₂, ou d'ammoniac NH₃, à haute température ceci afin d'obtenir une réaction de nitruration entre le silicium Si de la surface 105 du support 100 et les atomes d'azote N. Les conditions pour effectuer une telle étape sont décrites dans l'article publié dans le journal « Thin Solid films » 474 en 2005 aux pages 326 à 329 par Z. HONGLIANG et al.

Une telle étape permet de former à la surface 105 du support 100 une couche de nitrure de silicium SiN 103 au niveau de la zone libre 102. Une couche de nitrure de silicium 103 ainsi formée passive chimiquement et électriquement la surface 105 du support 100 au niveau de la zone libre 102. Avec une telle passivation de la surface 105 du support 100 au niveau de la zone libre 102, la croissance du deuxième matériau étant alors inhibée sur la zone libre 102, la sélectivité de la croissance du deuxième matériau sur les zones de formation 101 est augmentée par rapport à celle du premier et du deuxième mode de réalisation.

De préférence, les conditions de nitruration sont adaptées pour la formation d'une épaisseur de nitrure de silicium (SiN) inférieure à la moitié de la plus petite dimension surfacique des zones de formation 101. Une telle condition d'épaisseur de nitrure de silicium permet de fournir un contact électrique de bonne qualité entre le support et les fils.

Une telle couche nitrure de silicium 103 permet une optimisation de la passivation électrique du support sur les zones du support sur la zone libre 102 qui correspond aux parties de la surface qui ne sont pas en contact avec les fils, ceci sans nécessiter d'étapes supplémentaires, telles que mises en oeuvre dans l'art antérieur, qui font généralement appelles à de coûteuses étapes de lithographie.

Dans ce document, si les fils décrits sont des fils semiconducteurs dont la composition est homogène sur toute leur longueur, les fils formés lors de l'étape de formation des fils peuvent être, sans que l'on sorte du cadre de l'invention, des fils comportant une composition variée sur au moins une partie de leur hauteur, telle que par exemple de manière à former une jonction semiconductrice d'une diode électroluminescente. De la même façon, les fils formés lors de l'étape de formation des fils peuvent être du type coeur-coquille, la composition du fil étant variée radialement.

## Revendications

1. Procédé de fabrication d'au moins une structure semiconductrice (130) à la surface (105) d'un support (100) ledit procédé comportant les étapes consistant à :
- fournir le support (100) dont la surface comprend du silicium,
- former en contact avec au moins une zone (101) de la surface (105), qui est dite zone de formation, une couche (120) d'un premier matériau, le reste (102) de la surface (105), dit zone libre, restant libre du premier matériau, les dimensions de l'au moins une zone de formation (101) et le premier matériau étant adaptés pour la formation de la structure (130) avec des dimensions transversales comprises entre 100 nm et 1 µm, le premier matériau comportant du gallium , la formation de ladite couche (120) ayant lieu à une température inférieure à 600°C ,
- former la structure semiconductrice (130) en contact avec la couche (120) en déposant un deuxième matériau sensiblement identique au premier matériau, la structure semiconductrice (130) étant un fil semiconducteur,
le procédé de fabrication **étant caractérisé en ce que** l'étape de formation de la couche (120) d'un premier matériau comporte une sous-étape de dépôt du premier matériau du type dépôt physique en phase vapeur sélectionné dans le groupe comportant la pulvérisation cathodique et l'ablation laser pulsé.

2. Procédé de fabrication selon la revendication 1, dans lequel il est prévu, entre l'étape de formation de la couche (101) du premier matériau et l'étape de formation de la structure (130), une étape de nitruration de la zone libre (102) de la surface (105).

3. Procédé selon l'une quelconque des revendications précédentes, dans lequel l'étape de formation de la structure semiconductrice comporte une étape de croissance du premier matériau sur la couche (120) par épitaxie en phase vapeur utilisant des précurseurs organométalliques de manière à former au moins une partie de la structure semiconductrice en contact avec la couche (120).

4. Procédé selon l'une quelconque des revendications précédentes, dans lequel l'étape de formation de la couche (120) d'un premier matériau comporte les sous-étapes consistant à :
- former une couche (110) de protection recouvrant uniquement la zone libre (102) de la surface (105),
- déposer le premier matériau sur l'au moins une zone de formation (101), la zone libre (102) étant protégée par la couche de protection (110),
- retirer la couche de protection (110).

5. Procédé selon l'une quelconque des revendications 1 à 3, dans lequel l'étape de formation de la couche (120) comporte les sous-étapes consistant à :
- déposer le premier matériau sur toute la surface (105) du support (100),
- retirer la partie du premier matériau qui recouvre la zone libre (102).

6. Procédé selon l'une quelconque des revendications, dans lequel le support (100) comporte, au moins à sa surface, du silicium dans une proportion massique supérieure à 30%, la surface (105) du support (100) étant essentiellement composée de silicium.

7. Procédé de fabrication selon l'une quelconque des revendications précédentes dans lequel l'étape de formation de la structure (130) est une étape de formation d'un fil semiconducteur qui est, au moins pour sa partie en contact avec la couche (120), réalisé dans le premier matériau, le premier matériau étant un nitrure de gallium GaN.

## Patentansprüche

1. Verfahren zur Herstellung mindestens einer halbleitenden Struktur (130) auf der Oberfläche (105) eines Trägers (100), wobei das Verfahren die Schritte aufweist, die darin bestehen:
- Bereitstellen des Trägers (100), dessen Oberfläche Silicium umfasst,
- Bilden, im Kontakt mit mindestens einer Zone (101) der Oberfläche (105), die als Bildungszone bezeichnet wird, einer Schicht (120) aus einem ersten Material, wobei der Rest (102) der Oberfläche (105), bezeichnet als freie Zone, vom ersten Material frei bleibt, wobei die Abmessungen der mindestens einen Bildungszone (101) und das erste Material für die Bildung der Struktur (130) mit Querabmessungen geeignet sind, die zwischen 100 nm und 1 µm liegen, wobei das erste Material Gallium aufweist, wobei die Bildung der Schicht (120) bei einer Temperatur unter 600 °C stattfindet,
- Bilden der halbleitenden Struktur (130) im Kontakt mit der Schicht (120) durch Aufbringen eines zweiten Materials, das mit dem ersten Material etwa identisch ist, wobei die halbleitende Struktur (130) ein halbleitender Draht ist,
wobei das Herstellungsverfahren **dadurch gekennzeichnet ist, dass** der Schritt des Bildens der Schicht (120) aus einem ersten Material einen Unterschritt des Aufbringens des ersten Materials vom Typ physikalisches Aufbringen in der Dampfphase aufweist, der aus der Gruppe ausgewählt ist, die die Kathodenzerstäubung und die gepulste Laserablation aufweist.

2. Herstellungsverfahren nach Anspruch 1, wobei zwischen dem Schritt des Bildens der Schicht (101) aus dem ersten Material und dem Schritt der Bildung der Struktur (130) ein Schritt der Nitrierung der freien Zone (102) der Oberfläche (105) vorgesehen ist.

3. Verfahren nach einem der vorangehenden Ansprüche, wobei der Schritt des Bildens der halbleitenden Struktur einen Wachstumsschritt des ersten Materials auf der Schicht (120) durch Epitaxie in der Dampfphase aufweist, bei dem organometallische Vorläufer derart verwendet werden, dass mindestens ein Teil der halbleitenden Struktur im Kontakt mit der Schicht (120) gebildet wird.

4. Verfahren nach einem der vorangehenden Ansprüche, wobei der Schritt des Bildens der Schicht (120) aus einem ersten Material die Unterschritte aufweist, die darin bestehen:
- Bilden einer Schutzschicht (110), die nur die freie Zone (102) der Oberfläche (105) bedeckt,
- Aufbringen des ersten Materials auf mindestens eine Bildungszone (101), wobei die freie Zone (102) durch die Schutzschicht (110) geschützt ist,
- Entfernen der Schutzschicht (110).

5. Verfahren nach einem der Ansprüche 1 bis 3, wobei der Schritt des Bildens der Schicht (120) die Unterschritte aufweist, die darin bestehen:
- Aufbringen des ersten Materials auf die gesamte Oberfläche (105) des Trägers (100),
- Entfernen des Teils des ersten Materials, der die freie Zone (102) bedeckt.

6. Verfahren nach einem der Ansprüche, wobei der Träger (100) mindestens an seiner Oberfläche Silicium in einem Massenanteil von über 30 % aufweist, wobei die Oberfläche (105) des Trägers (100) im Wesentlichen aus Silicium besteht.

7. Herstellungsverfahren nach einem der vorangehenden Ansprüche, wobei der Schritt des Bildens der Struktur (130) ein Schritt des Bildens eines halbleitenden Drahts ist, der mindestens für seinen Teil im Kontakt mit der Schicht (120) aus dem ersten Material hergestellt ist, wobei das erste Material ein Galliumnitrid GaN ist.

## Claims

1. A method for manufacturing at least one semiconductor structure (130) on the surface (105) of a support (100), said method including the steps of:
- providing the support (100) whose surface comprises silicon,
- forming in contact with at least one zone (101) of the surface (105), which is called the formation zone, a layer (120) of a first material, the remainder (102) of the surface (105), called free zone, remaining free of the first material, the dimensions of the at least one formation zone (101) and the first material being adapted for the formation of the structure (130) with transverse dimensions comprised between 100 nm and 1 µm, the first material including gallium, the formation of said layer (120) taking place at a temperature below 600°C,
- forming the semiconductor structure (130) in contact with the layer (120) by depositing a second material substantially identical to the first material, the semiconductor structure (130) being a semiconductor wire,
the manufacturing method being **characterised in that** the step of forming the layer (120) of a first material includes a sub-step of depositing the first material of the physical vapour phase deposition type selected from the group including cathodic sputtering and pulsed laser ablation.

2. The manufacturing method according to claim 1, wherein provision is made, between the step of forming the layer (101) of the first material and the step of forming the structure (130), a step of nitriding the free zone (102) of the surface (105).

3. The method according to any one of the preceding claims, wherein the step of forming the semiconductor structure includes a step of growing the first material on the layer (120) by vapour phase epitaxy using organometallic precursors so as to form at least a portion of the semiconductor structure in contact with the layer (120).

4. The method according to any one of the preceding claims, wherein the step of forming the layer (120) of a first material includes the sub-steps of:
- forming a protective layer (110) covering only the free zone (102) of the surface (105),
- depositing the first material on the at least one formation zone (101), the free zone (102) being protected by the protective layer (110),
- removing the protective layer (110).

5. The method according to any one of claims 1 to 3, wherein the step of forming the layer (120) includes the sub-steps of:
- depositing the first material over the entire surface (105) of the support (100),
- removing the portion of the first material which covers the free zone (102).

6. The method according to any one of the claims, wherein the support (100) includes, at least on its surface, silicon in a mass proportion greater than 30%, the surface (105) of the support (100) being essentially composed of silicon.

7. The manufacturing method according to any one of the preceding claims, wherein the step of forming the structure (130) is a step of forming a semiconductor wire which is, at least for its part in contact with the layer (120), made of the first material, the first material being a gallium nitride GaN.
